# EUROPEAN PATENT SPECIFICATION

(11) **EP 3 740 051 B1**
(45) Date of publication and mention of the grant of the patent: **26.04.2023**
(21) Application number: 18900347.8
(22) Date of filing: 18.12.2018
(51) Int. Cl.: H05K 5/02, B01D 46/00, H05K 5/03, H05K 7/20

(54) **WATERPROOF STRUCTURE FOR VENT HOLE IN ELECTRONIC EQUIPMENT, HOUSING, AND ELECTRONIC EQUIPMENT**
WASSERDICHTE STRUKTUR FÜR LÜFTUNGSLOCH IN ELEKTRONISCHER AUSRÜSTUNG, GEHÄUSE UND ELEKTRONISCHE AUSRÜSTUNG
STRUCTURE ÉTANCHE À L'EAU POUR TROU D'ÉVENT DANS UN ÉQUIPEMENT ÉLECTRONIQUE, BOÎTIER ET ÉQUIPEMENT ÉLECTRONIQUE

(30) Priority: 11.01.2018 JP 2018002378
(43) Date of publication of application: 18.11.2020
(73) Proprietor: NEC Platforms, Ltd., Kanagawa 213-8511 (JP)
(72) Inventor: SASAKI, Yuta, Kawasaki-shi, Kanagawa 213-8511 (JP)
(74) Representative: Betten & Resch
(86) International application number: PCT/JP2018/046476
(87) International publication number: WO 2019/138798

(56) References cited:
- JP-A- H0 832 248
- JP-A- 2004 356 524
- JP-A- 2006 005 162
- JP-A- 2006 005 162
- JP-A- 2010 258 263
- JP-A- 2016 158 557
- JP-A- 2017 117 892
- JP-U- H0 640 350
- JP-U- S5 153 038
- US-A1- 2015 208 525

## Description

### Technical Field

The example embodiments relate to a waterproof structure for a ventilation opening of electronic equipment.

### Background Art

As electronic equipment, there is known, for example, a gate device arranged adjacent to an entrance/exit gate. The gate device is a device for determining admission or denial of entrance and exit based on a security code or personal authentication information inputted thereto and controlling the gate based on a result of determination. The gate device is a type of information processing device comprising a CPU (Central Processing Unit) for carrying out arithmetic processing of information in accordance with a program, an information storage unit for memorizing information, an input/output interface for a signal representative of information, and a housing accommodating those devices.

The information processing device such as the gate device is often provided with cooling means because heat is generated following an operation. Among the cooling means, air-cooling means using air as a coolant includes those for forcibly circulating air by a fan and those for naturally circulating air by convection without using the fan. In the latter air-cooling means, a housing is provided with a ventilation opening in order to discharge air heated to high temperature in response to heat conduction from a heat generating portion such as the CPU and, conversely, to suck outside air. The ventilation opening is preferably formed on a top surface of the housing so as to efficiently carry out ventilation.

The ventilation opening of the housing allows communication between the inside and the outside of the housing and, therefore, is desirably provided with means for preventing intrusion of unnecessary moisture, dust, and foreign substances into the housing. In particular, in case of a gate device which may be used outdoors, the means for preventing intrusion of moisture or the like is essential.

Each of Patent Literatures 1 and 2 discloses electronic equipment having a waterproof structure for a ventilation opening. The waterproof structure for the ventilation opening disclosed in Patent Literature 1 has a hydrophobic porous material layer configured to cover the ventilation opening formed on a top surface of a housing. The waterproof structure for the ventilation opening disclosed in Patent Literature 2 has a roof member configured to cover the ventilation opening formed on a top surface of a housing, and filters formed at exhaust ports on opposite sides of the roof member.

JP 2006 005162 A discloses a waterproof case which is mounted with a water repellent filter for breathing, and which is inexpensively manufactured for housing electronic equipment, wherein dusts or water is made to hardly stay in the mounting section of the water repellent filter.

US 2015/208525 A1 discloses an electronic control device that includes a housing having a plurality of housing members joined together, a housing vent hole formed through the housing member so as to extend in a thickness direction of the housing member, a protection wall covering an outer opening of the housing vent hole, with a gap left between the protection wall and the outer opening, a protection-wall vent hole formed in the protection wall at a position apart from the housing vent hole so as to extend from the gap in a radial direction of the housing vent hole, and an air-permeable waterproof membrane fixed to an inner opening of the housing vent hole. A vent passage with a bent part is formed between the air-permeable waterproof membrane and the protection-wall vent hole.

JP 2004 356524 A relates to a quick-curing resin having excellent heat-resistance, chemical resistance, mechanical properties and moldability and exhibiting low shrinkage by using a poly(N-cyclic imino ether) compound expressed by a specific structural formula

### Prior Art Literature(s)

### Patent Literature(s)

Patent Literature 1: JP 2006-231168 A
Patent Literature 2: JP 2000-037006 A

### Summary of the Invention

### Problems to be Solved by the Invention

The hydrophobic porous material layer disclosed in Patent Literature 1 may also be called a waterproof moisture-permeable film and may not always be sufficient in breathability although waterproofness and moisture permeability are excellent. The waterproof structure disclosed in Patent Literature 2 may not always be sufficient in regard to breathability in a height direction of the housing because the ventilation opening is provided with the roof member which itself has no breathability at all.

Thus, including those disclosed in Patent Literatures 1 and 2, the waterproof structure for the ventilation housing of the electronic equipment according to the related art of the example embodiments has a room for improvement in view of breathability. Therefore, it is desired to provide a waterproof structure for a ventilation opening of electronic equipment excellent in both breathability and waterproofness.

It is therefore an object of the example embodiments to provide a waterproof structure for a ventilation housing of electronic equipment excellent in both breathability and waterproofness.

It is another object of the example embodiments to provide a housing having the above-mentioned waterproof structure for the ventilation opening of the electronic equipment.

It is still another object of the example embodiments to provide electronic equipment having the above-mentioned housing.

### Means to Solve the Problem

According to one aspect of example embodiments, there is provided a waterproof structure provided at a ventilation opening formed on a top surface of a housing of electronic equipment, in which the water proof structure comprises a first filter mounted to the ventilation opening to be inclined in a depth direction or a width direction of the housing, in which the first filter comprises a hydromesh layer having a hydrophobic or a water-repellent property and breathability, characterized in that the waterproof structure for the ventilation opening of the electronic equipment further comprises a gutter portion extending below a downslope edge of the first filter along the downslope edge, and that the gutter portion is configured to receive moisture flowing down from a surface of the first filter and to discharge the moisture in an extending direction of the gutter portion.

According to another aspect of this invention, there is provided a housing of electronic equipment, comprising the above-mentioned waterproof structure for the ventilation opening of the electronic equipment.

According to still another aspect of this invention, there is provided electronic equipment having the above-mentioned housing.

### Effect of the Invention

The waterproof structure for the ventilation housing of the electronic equipment according to the example embodiments is excellent in both breathability and waterproofness.

### Brief Description of the Drawings

Fig. 1 is a perspective view of a gate device to which a waterproof structure for a ventilation opening of electronic equipment according to an example embodiment is applicable.
Fig. 2 is a perspective view of a main part of the waterproof structure for the ventilation opening of the electronic equipment according to the example embodiment.
Fig. 3 (a) and (b) are schematic sectional views for describing an operation of the waterproof structure for the ventilation opening of the electronic equipment according to the example embodiment.

### Mode for example embodiments

Hereinafter, a waterproof structure for a ventilation opening of electronic equipment according to the example embodiments will be described with reference to the drawings.

In the figure, a symbol W represents a width direction (including a leftward direction W1 and a rightward direction Wr) of a housing of the electronic equipment to which the waterproof structure for the ventilation opening is applicable, a symbol H represents a height direction (including a downward direction Hl and an upward direction Hu) of the housing, and a symbol D represents a depth direction (including a frontward direction Df and a rearward direction Dr) of the housing.

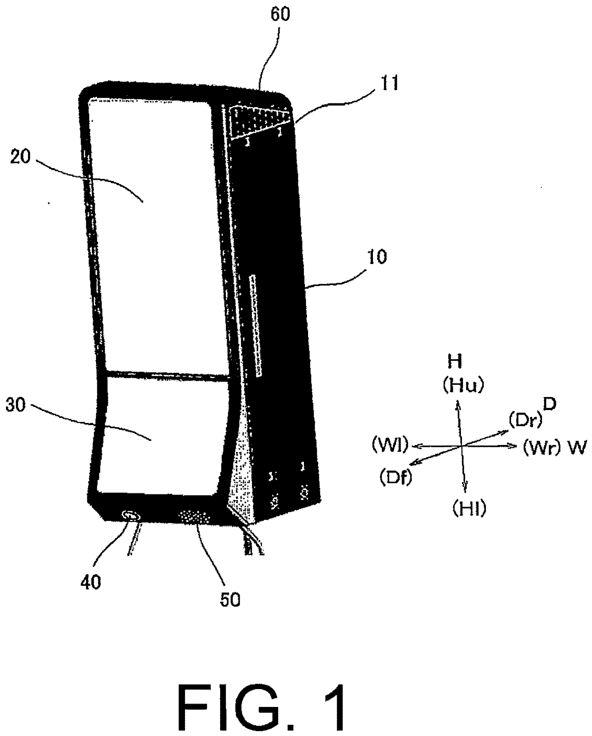

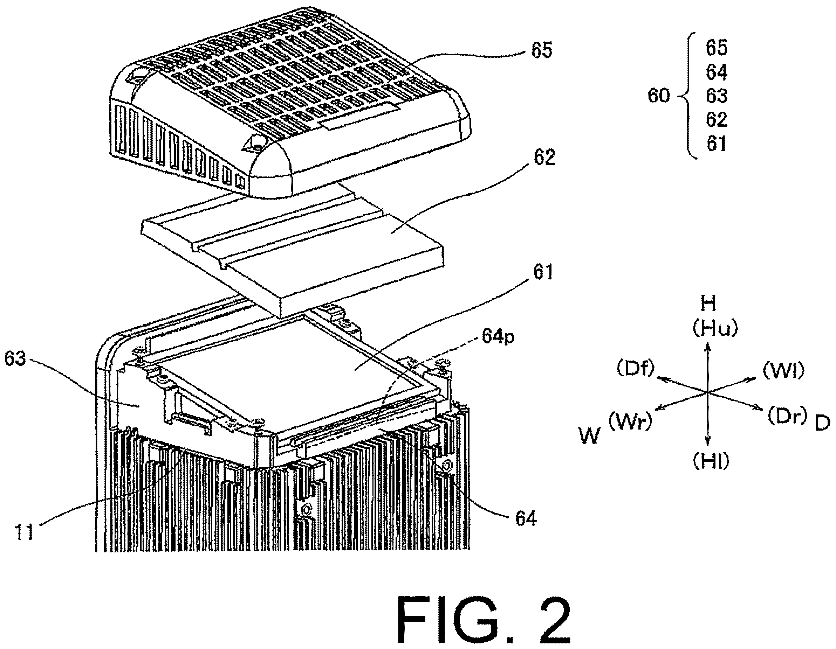

Referring to Figs. 1 to 3, a waterproof structure 60 according to an example embodiment is applied to a ventilation opening 11 of a housing 10 of a gate device as electronic equipment. The gate device is arranged adjacent to an entrance/exit gate.

The gate device comprises a circuit board 71, a CPU 72 which is mounted to the circuit board 71 and which is for carrying out arithmetic processing of information in accordance with a software program, an information storage unit (not shown) for memorizing information including the software program also, an input/output interface for a signal representative of information including personal authentication information also, and a housing 10 accommodating those devices. The input/output interface comprises a touch panel display 20, a touch pad 30 for contactless communication, a speaker microphone 50, and a power supply switch 40. The gate device determines admission or denial of entrance and exit based on a security code inputted from the touch panel display 20 or the personal authentication information inputted via the touch pad 30, and controls a gate based on a result of determination.

The gate device is provided with cooling means because the CPU 72 or the like generates heat following an operation. The cooling means naturally circulates air without using a fan. In order to discharge air heated to high temperature in response to heat conduction from a heat generating portion such as the CPU 72 and, conversely, to suck outside air, the housing 10 is provided with the ventilation opening 11. The ventilation opening 11 is formed on a top surface of the housing 10 in a height direction H in order to perform efficient ventilation. The CPU 72 is accommodated in the housing 10 so that an upper part of the housing 10 in the height direction H faces the ventilation opening 11.

The waterproof structure 60 according to the example embodiment comprises a first filter 61, a second filter 62, a frame member 63, a gutter portion 64, and a top cover 65.

The first filter 61 is fitted to the ventilation opening 11 of the housing 10 to be inclined in a depth direction D of the housing 10. The first filter 61 comprises a hydromesh layer having a hydrophobic or a water-repellent property and breathability.

The second filter 62 is mounted to the first filter 61 to be stacked thereon. The second filter 62 comprises a foam layer having water absorbability and breathability.

As a comparative example, for instance, a hydrophobic porous material layer (waterproof moisture-permeable film) such as Gore-Tex (registered trademark), is a material preventing intrusion of water and allowing passage of inside air but is not always sufficient in breathability although waterproofness is excellent.

In comparison, the hydromesh layer used as the first filter 61 in the example embodiments is excellent in both waterproofness and breathability. However, water may possibly pass through when high water pressure is applied. On the other hand, the hydromesh layer has a performance of retaining moisture under surface tension. Therefore, in the example embodiments, the moisture retained on a surface of the first filter 61 under surface tension is slipped down to be discharged by arranging the first filter 61 with a slope.

It is noted that the hydromesh layer forming the first filter 61 is, for example, meshed polyester fiber and may also be called a high-density mesh cloth.

Furthermore, the second filter 62 comprising the foam layer is stacked as an upper layer on the hydromesh layer which may allow passage of water under high water pressure. Thus, water pressure is sufficiently reduced before the moisture reaches the first filter 61. In addition, as a side effect, the foam layer also prevents intrusion of dust.

The foam layer forming the second filter 62 is, for example, urethane foam and has an open-cell foam structure in which air bubbles are interconnected. The foam layer allows a gas or a liquid to pass therethrough while meandering.

Therefore, the waterproof structure 60 according to the example embodiment simultaneously achieves excellent breathability of exhausting heat inside the housing by natural convection and excellent waterproofness of causing the incoming moisture to be reduced in pressure, to be repelled, to flow down, and to be discharged.

The frame member 63 is fitted to the ventilation opening 11 of the housing 10 and supports the first filter 61 so that the first filter is inclined in the depth direction D of the housing 10.

The gutter portion 64 extends below a downslope edge of the first filter 61 in parallel to the downslope edge. The gutter portion 64 receives the moisture flowing down from the surface of the first filter 61 and discharges the moisture in an extending direction (width direction W). The frame member 63 integrally has the gutter portion 64.

The gutter portion 64 extends below the downslope edge of the first filter 61 along the downslope edge, i.e., extends in the width direction W of the housing 10. The gutter portion 64 receives the moisture flowing down from the surface of the first filter 61 and discharges the moisture in the extending direction (width direction W). In particular, in this example embodiment, a bottom surface of the gutter portion 64 is inclined downward towards opposite ends from a center in the extending direction (width direction W) as a peak 64p. With the above-mentioned structure, the moisture is discharged from left and right side portions at a rear part of the housing so that the moisture is not retained on a rear surface of the housing. Accordingly, the housing of the electronic equipment can be fixed to a wall surface.

The top cover 65 is fitted to the housing 10 to cover the first filter 61 and the second filter 62. The top cover 65 has a mesh-like or a grid-like shape having a plurality of holes formed at least on an upper surface thereof. By providing the top cover 65, the first filter 61 and the second filter 62 are prevented from sticking of a foreign substance or from being tampered.

Next, description will be made of an operation of the waterproof structure for the ventilating opening of the electronic equipment according to the example embodiment.

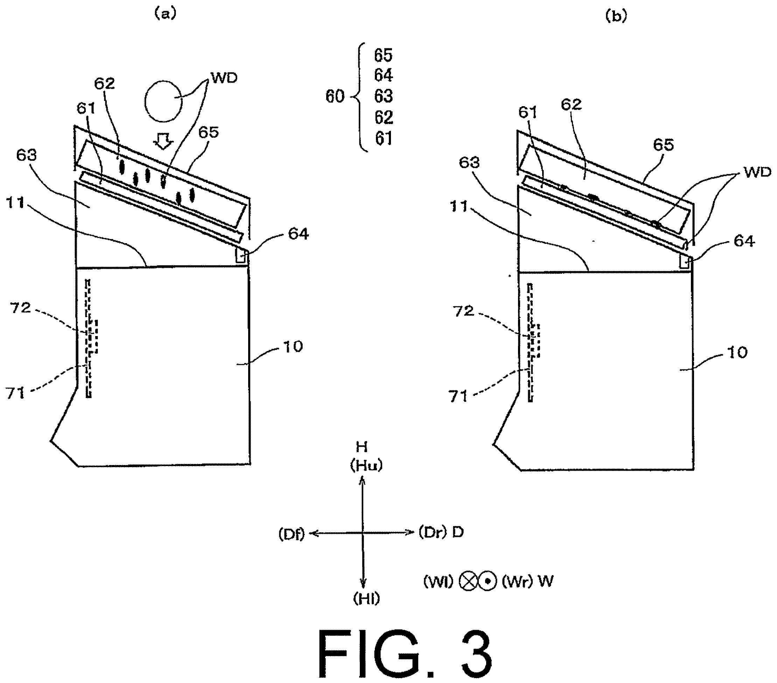

As shown in Fig. 3 (a), when the moisture WD falls down onto the top surface of the housing 10, the moisture WD is diffused inside the foam layer to become smaller water drops during passage through the second filter 62. The moisture WD is reduced in pressure or lowered in falling velocity.

Next, as shown in Fig. 3 (b), the moisture WD permeating the second filter 62 and reduced in pressure or falling velocity reaches the surface of the first filter 61 comprising the hydromesh layer. At the surface of the first filter 61, the moisture WD is repelled under surface tension. The moisture WD in the shape of the water drops flows along the slope of the first filter 61 in a rearward direction Dr and a downward direction Hl of the housing 10. Then, the moisture WD flowing down from the downslope edge of the first filter 61 is received by the gutter portion 64 and discharged along the extending direction of the gutter portion 64 (the width direction W of the housing 10). The gutter portion 64 may be inclined downward in the leftward direction W1 or the rightward direction Wr of the housing 10.

As described above, the moisture WD is prevented from intruding into the housing 10. In addition, incoming dust or foreign substances are also prevented by the second filter comprising the foam layer from intruding into the housing 10.

On the other hand, air exposed to heat conduction from the CPU 72 or the like generating heat in the housing 10 is discharged through the first filter 61 and the second filter 62 to the outside of the housing 10. Thus, heat release is achieved.

An object to which the waterproof structure for the ventilation opening of the electronic equipment according to the example embodiments is applicable is not limited to the gate device described above. For example, the waterproof structure according to the example embodiments is applicable to various types of electronic equipment, such as an oil feeding device in a self-service oil station system, which requires the ventilation opening of the housing to have breathability and to have a waterproof measure or a dustproof measure.

### Explanation of Reference Numerals

- 10: housing
- 11: ventilation opening
- 20: touch panel display
- 30: touch pad
- 40: power supply switch
- 50: speaker microphone
- 60: waterproof structure
- 61: first filter
- 62: second filter
- 63: frame member
- 64: gutter portion
- 64p: peak
- 65: top cover
- 71: circuit board
- 72: CPU (Central Processing Unit)

## Claims

1. A waterproof structure provided at a ventilation opening (11) formed on a top surface of a housing (10) of electronic equipment, the water proof structure comprising
a first filter (61) mounted to the ventilation opening (11) to be inclined in a depth direction (D) or a width direction (W) of the housing (10) wherein the first filter (61) comprises a hydromesh layer having a hydrophobic or a water-repellent property and breathability, **characterized in:**
**that** the waterproof structure for the ventilation opening of the electronic equipment further comprises a gutter portion (64) extending below a downslope edge of the first filter (61) along the downslope edge, and
**that** the gutter portion (64) is configured to receive moisture flowing down from a surface of the first filter (61) and to discharge the moisture in an extending direction of the gutter portion (64).

2. The waterproof structure for the ventilation opening of the electronic equipment according to claim 1, wherein the gutter portion (64) extends below a downslope edge of the first filter (61) in parallel to the downslope edge.

3. The waterproof structure for the ventilation opening of the electronic equipment according to claim 1, wherein the gutter portion (64) is inclined downward towards opposite ends thereof with a center in the extending direction as a peak (64p).

4. The waterproof structure for the ventilation opening of the electronic equipment according to any one of claims 1 to 3, further comprising a frame member (63) mounted to the ventilation opening (11) to support the first filter (61) so that the first filter (61) is inclined in the depth direction or the width direction of the housing (10).

5. The waterproof structure for the ventilation opening of the electronic equipment according to claim 4, wherein the frame member (63) is integral with the gutter portion (64).

6. The waterproof structure for the ventilation opening of the electronic equipment according to any one of claims 1 to 5, further comprising:
a second filter (62) mounted to the first filter (61) to be stacked thereon,
the second filter (62) comprising a foam layer having water absorbability and breathability.

7. The waterproof structure for the ventilation opening of the electronic equipment according to claim 6, further comprising:
a top cover (65) mounted to the housing (10) to cover the first filter (61) and the second filter (62),
the top cover (65) having a mesh-like or a grid-like shape with a plurality of holes formed at least on an upper surface thereof.

8. The waterproof structure for the ventilation opening of the electronic equipment according to any one of claims 1 to 7, wherein:
the first filter (61) is inclined downward towards a rear part of the housing (10) in the depth direction (D).

9. A housing of electronic equipment, comprising the waterproof structure for the ventilation opening of the electronic equipment according to any one of claims 1 to 8.

10. An electronic equipment having the housing according to claim 9.

11. The electronic equipment according to claim 10, further comprising:
at least one electronic component (72) which generates heat following an operation of the electronic equipment,
the electronic component (72) being accommodated in the housing (10) so that an upper part of the electronic component faces the ventilation opening (11).

## Patentansprüche

1. Wasserdichte Struktur, die an einer Belüftungsöffnung (11) vorgesehen ist, die auf einer oberen Fläche eines Gehäuses (10) eines elektronischen Geräts ausgebildet ist, wobei die wasserdichte Struktur Folgendes umfasst
einen ersten Filter (61), der an der Lüftungsöffnung (11) so angebracht ist, dass er in einer Tiefenrichtung (D) oder einer Breitenrichtung (W) des Gehäuses (10) geneigt ist, wobei der erste Filter (61) eine Hydromesh-Schicht umfasst, die eine hydrophobe oder eine wasserabweisende Eigenschaft und Atmungsaktivität aufweist, **dadurch gekennzeichnet,:**
**dass** die wasserdichte Struktur für die Belüftungsöffnung des elektronischen Geräts ferner einen Rinnenteil (64) umfasst, der sich unterhalb einer schrägen Kante des ersten Filters (61) entlang der schrägen Kante erstreckt, und
**dass** der Rinnenabschnitt (64) so konfiguriert ist, dass er von einer Oberfläche des ersten Filters (61) herabfließende Feuchtigkeit aufnimmt und die Feuchtigkeit in einer Erstreckungsrichtung des Rinnenabschnitts (64) ableitet.

2. Wasserdichte Struktur für die Belüftungsöffnung des elektronischen Geräts nach Anspruch 1, wobei sich der Rinnenteil (64) unterhalb einer abfallenden Kante des ersten Filters (61) parallel zu der abfallenden Kante erstreckt.

3. Die wasserdichte Struktur für die Belüftungsöffnung des elektronischen Geräts nach Anspruch 1, wobei der Rinnenabschnitt (64) zu seinen gegenüberliegenden Enden hin nach unten geneigt ist, mit einem Zentrum in der Erstreckungsrichtung als Spitze (64p).

4. Die wasserdichte Struktur für die Belüftungsöffnung des elektronischen Geräts nach einem der Ansprüche 1 bis 3, die ferner ein Rahmenelement (63) umfasst, das an der Belüftungsöffnung (11) angebracht ist, um den ersten Filter (61) zu tragen, so dass der erste Filter (61) in der Tiefenrichtung oder der Breitenrichtung des Gehäuses (10) geneigt ist.

5. Wasserdichte Struktur für die Belüftungsöffnung des elektronischen Geräts nach Anspruch 4, wobei das Rahmenelement (63) einstückig mit dem Rinnenteil (64) ist.

6. Die wasserdichte Struktur für die Belüftungsöffnung des elektronischen Geräts nach einem der Ansprüche 1 bis 5, die ferner Folgendes umfasst:
einen zweiten Filter (62), der an dem ersten Filter (61) befestigt ist, um auf diesem gestapelt zu werden,
wobei der zweite Filter (62) eine Schaumstoffschicht mit Wasserabsorptionsfähigkeit und Atmungsaktivität umfasst.

7. Die wasserdichte Struktur für die Belüftungsöffnung des elektronischen Geräts nach Anspruch 6, die ferner umfasst
eine obere Abdeckung (65), die an dem Gehäuse (10) angebracht ist, um den ersten Filter (61) und den zweiten Filter (62) abzudecken,
wobei die obere Abdeckung (65) eine maschenartige oder gitterartige Form mit einer Vielzahl von Löchern aufweist, die zumindest auf einer oberen Fläche davon ausgebildet sind.

8. Die wasserdichte Struktur für die Belüftungsöffnung des elektronischen Geräts nach einem der Ansprüche 1 bis 7, wobei:
der erste Filter (61) in Richtung eines hinteren Teils des Gehäuses (10) in Tiefenrichtung (D) nach unten geneigt ist.

9. Gehäuse eines elektronischen Geräts, das die wasserdichte Struktur für die Belüftungsöffnung des elektronischen Geräts nach einem der Ansprüche 1 bis 8 aufweist.

10. Ein elektronisches Gerät mit dem Gehäuse nach Anspruch 9.

11. Elektronisches Gerät nach Anspruch 10, ferner umfassend:
mindestens ein elektronisches Bauteil (72), das bei einem Betrieb des elektronischen Geräts Wärme erzeugt,
wobei das elektronische Bauteil (72) in dem Gehäuse (10) so untergebracht ist, dass ein oberer Teil des elektronischen Bauteils der Lüftungsöffnung (11) zugewandt ist.

## Revendications

1. Structure étanche à l'eau prévue au niveau d'une ouverture de ventilation (11) formée sur une surface de dessus d'un boîtier (10) d'un équipement électronique, la structure étanche à l'eau comprenant
un premier filtre (61) monté sur l'ouverture de ventilation (11) pour être incliné dans une direction de profondeur (D) ou une direction de largeur (W) du boîtier (10), le premier filtre (61) comprenant une couche hydromaillée ayant une propriété hydrophobe ou hydrofuge et de la respirabilité,
**caractérisée :**
**en ce que** la structure étanche à l'eau pour l'ouverture de ventilation de l'équipement électronique comprend en outre une partie de gouttière (64) s'étendant sous un bord descendant du premier filtre (61) le long du bord descendant, et
**en ce que** la partie de gouttière (64) est configurée pour recevoir de l'humidité s'écoulant vers le bas à partir d'une surface du premier filtre (61) et pour décharger l'humidité dans une direction d'extension de la partie de gouttière (64).

2. Structure étanche à l'eau pour l'ouverture de ventilation de l'équipement électronique selon la revendication 1, dans laquelle la partie de gouttière (64) s'étend sous un bord descendant du premier filtre (61) parallèlement au bord descendant.

3. Structure étanche à l'eau pour l'ouverture de ventilation de l'équipement électronique selon la revendication 1, dans laquelle la partie de gouttière (64) est inclinée vers le bas vers des extrémités opposées de celle-ci avec un centre dans la direction d'extension comme pic (64p).

4. Structure étanche à l'eau pour l'ouverture de ventilation de l'équipement électronique selon l'une quelconque des revendications 1 à 3, comprenant en outre un organe formant cadre (63) monté sur l'ouverture de ventilation (11) pour supporter le premier filtre (61) de sorte que le premier filtre (61) soit incliné dans la direction de profondeur ou la direction de largeur du boîtier (10).

5. Structure étanche à l'eau pour l'ouverture de ventilation de l'équipement électronique selon la revendication 4, dans laquelle l'organe formant cadre (63) est solidaire de la partie de gouttière (64).

6. Structure étanche à l'eau pour l'ouverture de ventilation de l'équipement électronique selon l'une quelconque des revendications 1 à 5, comprenant en outre :
un deuxième filtre (62) monté sur le premier filtre (61) pour être empilé sur celui-ci,
le deuxième filtre (62) comprenant une couche de mousse ayant une capacité d'absorption d'eau et de la respirabilité.

7. Structure étanche à l'eau pour l'ouverture de ventilation de l'équipement électronique selon la revendication 6, comprenant en outre :
un couvercle de dessus (65) monté sur le boîtier (10) pour couvrir le premier filtre (61) et le deuxième filtre (62),
le couvercle de dessus (65) ayant une forme de maille ou de grille, une pluralité de trous étant formés au moins sur une surface supérieure de celui-ci.

8. Structure étanche à l'eau pour l'ouverture de ventilation de l'équipement électronique selon l'une quelconque des revendications 1 à 7, dans laquelle :
le premier filtre (61) est incliné vers le bas, vers une partie arrière du boîtier (10) dans la direction de profondeur (D).

9. Boîtier d'un équipement électronique, comprenant la structure étanche à l'eau pour l'ouverture de ventilation de l'équipement électronique selon l'une quelconque des revendications 1 à 8.

10. Équipement électronique ayant le boîtier selon la revendication 9.

11. Équipement électronique selon la revendication 10, comprenant en outre :
au moins un composant électronique (72) qui génère de la chaleur suite à un fonctionnement de l'équipement électronique,
le composant électronique (72) étant logé dans le boîtier (10) de sorte qu'une partie supérieure du composant électronique soit tournée vers l'ouverture de ventilation (11).
